# EUROPÄISCHE PATENTSCHRIFT

(11) **EP 3 696 559 B1**
(45) Veröffentlichungstag und Bekanntmachung des Hinweises auf die Patenterteilung: **16.08.2023**
(21) Anmeldenummer: 20155673.5
(22) Anmeldetag: 05.02.2020
(51) Int. Cl.: G01R 33/31, G01R 33/30

(54) **MAS-PROBENKOPF MIT THERMISCH ISOLIERTER PROBENKAMMER**
MAS SAMPLE HEAD WITH THERMALLY INSULATED SAMPLE CHAMBER
TÊTE DE SONDE MAS À CHAMBRE À ÉCHANTILLONS THERMIQUEMENT ISOLÉE

(30) Priorität: 14.02.2019 DE 102019202001
(43) Veröffentlichungstag der Anmeldung: 19.08.2020
(73) Patentinhaber: Bruker BioSpin GmbH, 76287 Rheinstetten (DE)
(72) Erfinder: Osen, David, 76275 Ettlingen (DE); Krahn, Alexander, 76137 Karlsruhe (DE); Schalck, Constantin, 76726 Germersheim (DE)
(74) Vertreter: Kohler Schmid Möbus Patentanwälte

(56) Entgegenhaltungen:
- US-A- 4 587 492

## Beschreibung

Die Erfindung betrifft einen MAS-Probenkopf, der im Betrieb in einer Magnetbohrung einer NMR-MAS-Anordnung angeordnet ist, mit einer Probenkammer, welche einen MAS-Stator zur Aufnahme eines MAS-Rotors sowie eine HF-Spule umfasst, die zum Einstrahlen von HF-Pulsen in eine NMR-Messprobe und/oder zum Empfangen von HF-Signalen aus der NMR-Messprobe dient, wobei eine Temperiervorrichtung vorhanden ist, um während einer NMR-Messung Gas auf einer ersten variablen Temperatur T₁ in die Probenkammer und durch den MAS-Stator hindurch zu leiten um die Temperatur der NMR Probe einzustellen und um gleichzeitig Druckgas auf einer zweiten variablen Temperatur T₂ um die Probenkammer herum zu leiten.

Ein derartiger MAS-Probenkopf ist bekannt aus der US 4,587,492 A (= Referenz [1]).

### Hintergrund

Die NMR(=Kernspinresonanz)-Spektroskopie ist ein leistungsfähiges Verfahren der instrumentellen Analytik, mit dem insbesondere die chemische Zusammensetzung von Messproben bestimmt werden kann. Dabei werden HF(=Hochfrequenz)-Pulse in die Messprobe, die sich in einem starken statischen Magnetfeld befindet, eingestrahlt, und die elektromagnetische Reaktion der Probe wird vermessen. Zur Verringerung von Verbreiterungen der gemessenen NMR-Signale aufgrund anisotroper Wechselwirkungen ist es zudem bekannt, eine NMR-Feststoffprobe während der spektroskopischen Vermessung unter dem so genannten "Magischen Winkel" von ca. 54,74° gegenüber dem statischen Magnetfeld verkippt rotieren zu lassen ("MAS" = Magic Angle Spinning). Der MAS-Rotor wird in einem MAS-Stator gasgelagert angeordnet, temperiert und mit einem weiteren Gasstrom in Rotation versetzt. Das bedeutet, dass NMR-MAS Probenköpfe einen mit Druckgas betriebenen Stator umfassen, welcher mehrere voneinander getrennte Druckgaszufuhren für die genannten Zwecke umfasst, die typischerweise von einem Fußkasten des Probenkopfes bis hin zum Messbereich, dem eigentlichen MAS-Modul, geführt werden.

Die vorliegende Erfindung betrifft einen MAS-Probenkopf zur Einbringung in die Bohrung des Magnetsystems eines NMR-Spektrometers. Die MAS-Probenkammer wird im Betrieb je nach Anwendung auf Temperaturen zwischen -120°C und +400°C gebracht. Die relative Wärme oder Kälte, die im Wesentlichen aus dem Druckgas für die Lagerdüsen und/oder den Temperierdüsen stammt, wird bislang unkontrolliert nach außen abgeführt, wo die nächste Umgebung dann zwangsläufig auf dieselbe Temperatur gebracht wird. Dies betrifft insbesondere die direkt außerhalb eines üblicherweise eingesetzten HF-Abschirmrohres, jedenfalls radial in unmittelbarer Nähe der Wandung der Magnetbohrung befindlichen NMR-Shimspulen, welche dann unkontrolliert aufgewärmt oder abgekühlt und dadurch in ihrer Funktion beeinträchtigt werden.

Bislang wird das Innere der Magnetbohrung, insbesondere des HF-Abschirmrohres, zwar mit einem sogenannten Flush-Gas (meist N₂ oder getrocknete Luft) gespült, jedoch ist die thermische Isolierung gerade im sensiblen Bereich des Shimrohres nur mangelhaft, da die Wärme nicht effizient durch das Flush-Gas aufgenommen und in eine definierte Richtung abgeführt wird.

Die Abgase der Probenkammer strömt durch die Abluftbohrung im HF-Abschirmrohr und verlässt das Magnetsystem nach oben. Dadurch wird die komplette obere Sektion des Probenkopfes und des Shim-Oberteils ungewollt mit temperiert, was zu einer Überhitzung oder aber einer Unterkühlung des Spektrometerbereichs oberhalb des Probenkopfes führen kann. Das angrenzende Shimrohr, welches typischerweise aus AI gefertigt ist, kann die Wärme aufnehmen und in die sensiblen Bereiche der Shimspulen weiterleiten. Der Austritt einer unterkühlten Luft aus dem Probenkopf in die Raumtemperatur-Bohrung des Magneten kann im Kontakt mit der Außenluft zu einer Vereisung der Komponenten führen oder zum Eindringen von Kondenswasser.

Ein zusätzliches Problem ergibt sich, wenn durch Installation eines Probentransfer-Systems oder Probenroboters der Staudruck ansteigt, so dass die abströmenden Gase nach unten durch die Elektronik des Probenkopfes abfließen.

Nachteile des aktuellen Standes liegen unter anderem darin, dass zahlreiche Probenkopf- und Magnetkomponenten für diese Temperaturzyklen ausgelegt werden müssen. Im Extremfall kann es zu einer Abschaltung der Proben-Temperierung und zu Überhitzung oder Vereisung von Spektrometer-Komponenten kommen.

Die US 2010/0026302 A1 (=Referenz [2]) beschreibt ein MAS-System, das die NMR-Probe von der Spule (und den HF-Komponenten) thermisch isoliert. Temperierte Gasströme werden lediglich dazu verwendet, die Messprobe im Spinner selbst zu temperieren, wobei die Abluft durch eine Leitung nach außen geführt wird. Der Bereich außerhalb der thermischen Isolierung ist gegenüber der Außenwandung des Probenkopfes nicht isoliert, wodurch ein Wärmeübergang vom Probenkopf zum Shimsystem stattfinden kann. Entsprechend wird also die komplette Probenkammer gegenüber der Umgebung isoliert. Spule und Probe haben in etwa die gleiche Temperatur.

Die US 2015/0048829 A1 (=Referenz [3]) offenbart einen MAS Probenkopf, in welchem die temperierte Abluft aus dem Stator (also Drive-, Temperier- und Bearinggas-Ströme) verwendet wird, um in einem Wärmetauscher innerhalb eines Wärmeschilds ("insulation screen") Energie aus der Abluft abzugeben, die entweder zu heiß (Verbrennungsgefahr für den Benutzer) oder zu kalt (Kondensationsgefahr) sein kann. Ein gesonderter Gasstrom ist nicht vorgesehen. Die Referenz [3] beschreibt auch nicht, dass und wie die Temperaturunterschiede vom Stator zum Außenbereich des Probenkopfes isoliert werden können, denn der Wärmetauscher wird ja dort genau mit den temperierten Gasen beschickt, wobei die thermische Kopplung des Wärmetauschers mit dem Schild eigentlich bewirkt, dass der Außenbereich des Probenkopfes die Temperatur des Innenbereiches annimmt.

Die US 2005/0122107 A1 (=Referenz [4]) stellt eine NMR-Sonde bereit, die einen vakuumisolierten Behälter und einen Detektorteil aufweist. Der Detektorabschnitt wird durch eine Kühleinrichtung gekühlt, um die Empfindlichkeit zu erhöhen, bei der NMR-Signale erfasst werden. Irgendeine Art von thermischer Isolierung durch einen Gasstrom ist nicht offenbart. Die eingangs zitierte Referenz [1] zeigt eine Temperiervorrichtung für einen NMR-MAS Probenkopf, welcher axial von einem temperierten Gasstrom durchströmt wird. In diesem Stand der Technik wird beabsichtigt, mit dieser Temperiervorrichtung nicht nur die NMR-Messprobe auf einer konstanten Temperatur zu halten, sondern auch eine thermische Barriere zu schaffen zwischen der im innersten Bereich der Magnetbohrung angeordneten Messprobe und den radial weiter außen angeordneten Gradientenspulen. Dazu soll ein vom Antriebs- und Temperierstrom des Rotors getrennter, mit radialem Abstand um den MAS-Stator herum geführter Abschirm-Gasstrom eingesetzt werden, der radial nach außen in Richtung auf den NMR-Magneten, aber wohl noch innerhalb der Magnetbohrung, von einer Hülle ("solid thermal barrier means") umgeben ist. Zusammen mit dem Abschirm-Gasstrom soll diese Hülle eine thermische Barriere zu den Gradientenspulen ausbilden. Eine thermische Abkapselung dieses Abschirm-Gasstromes vom Bereich der Probenkammer ist allerdings nicht vorgesehen.

Wünschenswert wäre hingegen aber auch eine körperliche, räumliche und vor allem thermisch wirksame Trennung der Antriebs- und Temperierströme vom Abschirm-Gasstrom.

### Aufgabe der Erfindung

Der vorliegenden Erfindung liegt demgegenüber die Aufgabe zugrunde, mit möglichst einfachen technischen Mitteln und ohne erheblichen konstruktiven Zusatzaufwand einen MAS- Probenkopf der eingangs definierten Art so zu modifizieren, dass eine Abführung der Wärme beziehungsweise Kälte, die in der Probenkammer herrscht, nach außen möglichst effizient verhindert wird, sodass damit außen liegende Bauteile des Probenkopfes, insbesondere die temperatursensiblen Shimspulen, gegenüber den Stator-nahen Teilen effektiv thermisch abgeschirmt sind. Des Weiteren soll durch die Erfindung auch ein deutlich größerer Temperaturbereich für die NMR-Messung nutzbar gemacht werden.

### Kurze Beschreibung der Erfindung

Diese komplexe Aufgabe wird auf ebenso überraschend einfache wie wirkungsvolle Weise mit den Merkmalen der kennzeichnenden Teile der Ansprüche 1 bzw. 13 gelöst. Insbesondere wird bei einem gattungsgemäßen MAS - Probenkopf mit den eingangs definierten Merkmalen die Probenkammer mittels einer Kapsel-Einrichtung mindestens in azimutaler Richtung um die Achse der Magnetbohrung sowie entgegen der Strömungsrichtung des Druckgases umschlossen und ist derart angeordnet, dass ein Luftspalt zwischen der Probenkammer und der Magnetbohrung der NMR-MAS-Anordnung vorhanden ist.

Damit wird die Probenkammer, welche auch die MAS Turbine beinhaltet, von der Magnetbohrung oder einem umgebenden HF-Abschirmrohr effektiv thermisch isoliert. Diese thermische Isolation wird erfindungsgemäß dadurch bewirkt, dass die Probenkammer mit dem MAS-System umfassend den MAS-Stator so gekapselt ist, dass alle temperierten Abgase sowohl aus den Lagerdüsen als auch den Antriebsdüsen ausschließlich durch die dafür vorgesehenen Kanäle kontrolliert in eine Richtung (in der Regel nach oben) aus dem Probenkopf herausgeleitet werden. Insbesondere das Temperiergas, aber auch die Lagergase sind abhängig von der jeweiligen Anwendung stark temperiert, wodurch die Probenkammer während der Messung die Temperatur des Lagergases annimmt.

Die erfindungsgemäße Kapsel-Einrichtung kann als formstarre Röhre, aber auch als Folien-Überzug oder als Kunststoff-Hülse ausgeführt sein. In jedem Fall sollte die Kapsel-Einrichtung aus einem temperaturbeständigen Material aufgebaut sein. So kommen als Material beispielsweise Polyimide in Frage, etwa eine Kapton^{®}-Folie. Außerdem wird in der Regel eine Bodenplatte als unterer Abschluss der Kapsel-Einrichtung vorgesehen sein, die vorzugsweise formstarr ausgeführt ist und die Durchführungen der elektrischen und pneumatischen Zuleitungen aufnimmt.

An dieser Stelle sei ausdrücklich darauf hingewiesen, dass sich die Vorteile der Erfindung nicht nur bei vertikalen NMR-Spektrometern, sondern ebenso auch bei NMR-Systemen mit horizontaler oder schräg liegender z-Achse erzielen lassen. Die angegebenen axialen Positionen müssen dann nicht mehr notwendig "oberhalb" beziehungsweise "unterhalb" des NMR-Magnetsystems liegen, sondern gegebenenfalls auch "rechts" oder "links" neben demselben. Jedenfalls spielt die Schwerkraft bei der Wirkungsweise der vorliegenden Erfindung eine eher untergeordnete Rolle.

### Bevorzugte Ausführungsformen der Erfindung

Ganz besonders bevorzugte Ausführungsformen des erfindungsgemäßen Probenkopfs zeichnen sich dadurch aus, dass elektronische Bauteile umfassend Resonatorstrukturen und elektrische Übertragungsleitungen, vorzugsweise sämtliche elektronischen Bauteile mit Ausnahme der HF-Spule, außerhalb der Kapsel-Einrichtung, insbesondere im Bereich des Druckgases auf der zweiten variablen Temperatur T₂, angeordnet sind.

Elektronische Resonatorstrukturen sind in der Regel sehr temperatursensibel und sollten daher nicht mit der Probenkammer temperiert werden. Deshalb befinden sie sich im Bereich der zweiten variablen Temperatur T₂. Im Vergleich zum Stand der Technik nach Referenz [1] ist hierzu aber keine "thermal barrier" notwendig.

Bei einer Klasse von vorteilhaften Ausführungsformen der Erfindung ist ein Abgassystem vorgesehen, welches die Gasströme auf der ersten variablen Temperatur T₁ und auf der zweiten variablen Temperatur T₂ räumlich voneinander getrennt aus dem Probenkopf hinausleitet.

Wenn sich die Temperierströme bei T₁ und T₂ schon im Probenkopf vermischen, kann der Temperaturübertrag auf sensible Magnetbereiche im Zentrum des Magneten durch die Wärmeleitung der Bauteile übertragen werden. Vorteilhaft ist es daher, wenn der Temperiergasstrom bei T₁ innerhalb des Gasstroms bei T₂ geführt wird und die Ströme erst weit oberhalb des Messzentrums des Magneten zusammengeführt werden, denn im Messzentrum befindet sich typischerweise das temperatursensible Shimsystem.

Weitere vorteilhafte Ausführungsformen der Erfindung sehen vor, dass der Luftspalt zwischen Probenkammer und Magnetbohrung zur Durchleitung des Druckgases auf der zweiten variablen Temperatur T₂ azimutal umlaufend innerhalb der Magnetbohrung ausgebildet ist.

Auf diese Weise wird ein umlaufender gleichmäßiger Isoliereffekt erzielt, wobei kein Bereich signifikant wärmer oder kälter als ein anderer Bereich ist.

Vorteilhafte Weiterbildungen dieser Ausführungsformen zeichnen sich dadurch aus, dass die Kapsel-Einrichtung und die Magnetbohrung jeweils eine zylindrische Form mit parallelen, insbesondere identischen, Zylinderachsen haben, und dass ein Luftspalt zwischen Kapsel-Einrichtung und Magnetbohrung umlaufend mit gleichem Querschnitt gestaltet ist.

Der Kühlungs- beziehungsweise Aufwärmungseffekt ist nämlich besonders gleichmäßig und effizient, wenn die Strömungsgeschwindigkeit umlaufend dieselbe ist. Ansonsten können sich Temperaturgradienten ausbilden. Durch diesen zylinderförmigen Luftspalt kommt man einer idealen laminaren Strömung am nächsten.

Bevorzugt sind auch Ausführungsformen der Erfindung, bei denen der Luftspalt zwischen Probenkammer und Magnetbohrung zur Durchleitung des Druckgases auf der zweiten variablen Temperatur T₂ eine sich in axialer Richtung der Magnetbohrung erstreckende radiale Verengung im axialen Bereich der Probenkammer aufweist, die vorzugsweise zwischen 0,1mm und 1 mm beträgt.

Dadurch beschleunigt sich der Gasstrom und der Abtransport der überschüssigen Wärme (Kälte) ist effizienter und der Isoliereffekt wird erhöht. In der Praxis bewähren sich auch Ausführungsformen, bei denen der Luftspalt zwischen Probenkammer und Magnetbohrung zur Durchleitung des Druckgases auf der zweiten variablen Temperatur T₂ so ausgelegt ist, dass ein Gasstrom mit einer Gasmenge von 2 bis 50 Normliter/min, vorzugsweise zwischen 10 und 25 Normliter/min, hindurch strömen kann. Der Gasstrom hat nämlich bei höherer Gasmenge eine bessere Effizienz beim Abtransport der überschüssigen Wärme (beziehungsweise Kälte).

Von hohem praktischem Vorteil ist der erfindungsgemässe MAS-Probenkopf gemäss Anspruch 1, welcher sich dadurch auszeichnet, dass der MAS-Stator von einem Abschirmrohr aus elektrisch leitfähigem Material zum Abschirmen von HF-Strahlung umgeben ist, und dass die Kapsel-Einrichtung derart innerhalb des Abschirmrohres angeordnet ist, dass der Gasstrom mit dem Druckgas auf der zweiten variablen Temperatur T₂ außerhalb der Probenkammer durch einen Luftspalt zwischen der Kapsel-Einrichtung und dem Abschirmrohr hindurch geleitet wird.

Der Temperierstrom T₁ kann innerhalb des Abschirmrohres geführt werden. Da das Abschirmrohr aus Metall ist, welches typischerweise eine gute Wärmeleitfähigkeit zum Magneten hin besitzt, ist es umso wichtiger, dass die Wärme aus dem Probenkopf nicht zum Abschirmrohr gelangt.

Bei weiteren bevorzugten Ausführungsformen der Erfindung weist die Kapsel-Einrichtung mindestens zwei Einlässe für Gas von variabler Temperatur T₁ auf, durch welche mindestens zwei Teilströme des Gases von variabler Temperatur T₁ in die Probenkammer eingeleitet werden können, wobei die Teilströme jeweils Gas von unterschiedlichen Temperaturen T'₁, T"₁, T‴₁ und/oder für unterschiedliche Funktionen, vorzugsweise zur Gaslagerung des MAS-Rotors oder zum Rotationsantrieb des MAS-Rotors oder zur Temperierung einer NMR-Messprobe, enthalten.

Es wird jedenfalls nach aktueller Bauart der Anlage- mindestens ein Gasstrom benötigt, mit dem der Rotor gelagert (und zumeist auch temperiert wird) sowie ein zweiter, mit dem der Rotor mechanisch angetrieben wird. Die Temperierung des Rotors kann aber auch -unabhängig von dessen Lagerungdurch einen dritten Gasstrom bewirkt werden.

Bei einer Klasse von vorteilhaften Ausführungsformen des erfindungsgemäßen Probenkopfes erstreckt sich das Abgassystem um eine Strecke s vom MAS-Stator weg in die Magnetbohrung, die größer ist als der maximale Außendurchmesser des MAS-Stators, insbesondere s > 3cm.

Die Gasströme bei einer Temperatur T₁ sollen nämlich möglichst weit vom Magnetzentrum auf die Magnetbohrung treffen, da diese den Magneten sowie das Shimsystem beeinflussen.

Bevorzugt sind Weiterbildungen dieser Klasse von Ausführungsformen, bei denen die aus der Probenkammer austretenden Gasströme zumindest auf einem Teil der Strecke s thermisch voneinander isoliert geführt werden und zwar dergestalt, dass das Gas von variabler Temperatur T₁ innerhalb des Druckgases auf der zweiten variablen Temperatur T₂ geführt wird.

Dies hat den zusätzlichen Vorteil, dass der thermische Einfluss auf das Shimsystem weiter verringert wird.

Das Abgassystem kann eine Mehrzahl von Bohrungen umfassen, die vorzugsweise im Abschirmrohr angebracht und derart dimensioniert sind, dass Länge /Durchmesser der Bohrungen mindestens einen Faktor 4 beträgt.

In der Praxis bewähren sich auch Ausführungsformen, bei denen das Abgassystem derart ausgebildet ist, dass die aus der Probenkammer austretenden Gasströme nach Bedarf gemeinsam oder einzeln geheizt und/oder gekühlt und/oder vermischt werden können.

Dadurch kann die Temperatur des Abgases auf Raumtemperatur bzw. nahe Raumtemperatur gebracht werden, wodurch das Shimsystem nicht beeinträchtigt wird und auch das Kondensieren oder das Anfrieren der Raumfeuchtigkeit am Austrittspunkt der Magnetbohrung, der auf Raumtemperatur ist, bzw. Verbrennungsgefahr für den Benutzer verhindert wird.

Bevorzugt sind auch Weiterbildungen dieser obigen Ausführungsformen, bei denen in dem vom MAS-Stator abgewandten Teil des Abgassystems eine Heiz- bzw. Kühleinrichtung, vorzugsweise eine elektrische Heizwendel, ein Pelletierelement bzw. ein Wärmetauscher, vorgesehen ist, mit welcher aus der Probenkammer austretende Gasströme, vorzugsweise das Gas von variabler Temperatur T₁, bei Bedarf aufgeheizt oder abgekühlt werden können.

Bei stark unterkühlten Messungen T₁<0°C kann es zu Vereisungen kommen, wo der Gasstrom aus der Bohrung austritt. Wenn temperiert wird, passiert das nicht. Bei Messungen mit sehr hohen Temperaturen T₁>100°C besteht andererseits Verbrennungsgefahr für den Benutzer. Diese sollte ebenfalls unbedingt vermieden werden.

Eine besonders bevorzugte Ausführungsform, sieht vor, dass beim erfindungsgemäßen MAS-Probenkopf im Anschluss an das Abgassystem ein Transfersystem angeschlossen ist, in welchem die Abgasströme weiterhin voneinander getrennt geführt werden, insbesondere bis zu einer Mischkammer.

Dies hat den Vorteil, dass die Gasströme bei einer Temperatur T₁ nämlich möglichst weit vom Magnetzentrum auf die Magnetbohrung treffen, da diese den Magneten sowie das Shimsystem beeinflussen. Das Transfersystem kann als ein vom Probenkopf getrenntes Bauteil ausgeführt sein, das formschlüssig auf den Probenkopf aufgesetzt wird, um die Gasströme aufzunehmen.

Vorteilhaft ist schließlich auch eine Ausführungsform, bei der der MAS-Stator, insbesondere zur Einstellung des MAS-Winkels, verschwenkbar beziehungsweise drehbar gelagert ist. Durch die Drehbarkeit des Stators im Probenkopf kann bei begrenztem Raum das Ein- und Ausführen des MAS-Rotors weiter erleichtert werden; enge Kurven werden vermieden. Durch die Drehbarkeit des Stators kann zum Ein- und Ausschleusen der Winkel der Stator-Lagerachse gegenüber der Längserstreckungsrichtung des Rohres (die regelmäßig zumindest in guter Näherung der Richtung des statischen Magnetfelds im NMR-Magneten entspricht) verglichen mit dem magischen Winkel verkleinert werden.

In den Rahmen der vorliegenden Erfindung fällt auch eine NMR-MAS-Messanordnung mit einem erfindungsgemäßen MAS-Probenkopf der oben beschriebenen Art, die auch ein NMR-Magnetsystem und gegebenenfalls ein Shimsystem sowie einen Kryostaten umfassen kann.

In den Rahmen der vorliegenden Erfindung fällt aber auch ein Verfahren zum Betrieb einer NMR-MAS-Anordnung mit einem MAS-Probenkopf der oben beschriebenen erfindungsgemäßen Art, welches dadurch gekennzeichnet, dass die Temperatur der Gasströme auf der ersten variablen Temperatur T₁ zwischen -120°C und 400°C und das Druckgas auf der zweiten variablen Temperatur T₂ zwischen 10°C und 30°C gehalten wird.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen im Rahmen des durch die Ansprüche definierten Schutzumfangs Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert.

Es zeigen:
- Fig. 1: eine grob-schematische Vertikalschnitt-Darstellung einer Ausführungsform des erfindungsgemäßen MAS-Probenkopfes mit HF-Abschirmrohr; und
- Fig. 2: eine ähnliche Ausführungsform wie in Fig. 1, aber *ohne* HF-Abschirmrohr.

Die vorliegende Erfindung befasst sich mit einem speziell modifizierten Probenkopf für ein NMR-Spektrometer, insbesondere für MAS-Anwendungen, bei welchem eine räumliche und damit vor allem auch thermische Trennung der Probenkammer von temperatursensiblen Baugruppen außerhalb derselben erzielt wird.

Die aus Gründen der Übersichtlichkeit bewusst sehr schematisch gehaltenen Figuren der Zeichnung zeigen jeweils in einer vertikalen Schnittebene einen erfindungsgemäßen **MAS-Probenkopf 1** zum Einführen in eine Magnetbohrung eines NMR-Magnetsystems, welches in der Zeichnung ebenso wie das NMR-Spektrometer nicht näher dargestellt ist.

Der Probenkopf 1 ist im Betrieb in einer **Magnetbohrung 2** einer NMR-MAS-Anordnung angeordnet und umfasst eine **Probenkammer 3**, welche einen **MAS-Stator 4** zur Aufnahme eines MAS-Rotors sowie eine HF-Spule enthält, die zum Einstrahlen von HF-Pulsen in eine **NMR-Messprobe 5,** die sich innerhalb eines MAS-Rotors befindet, und/oder zum Empfangen von HF-Signalen aus der NMR-Messprobe 5 dient. Auch ist eine Temperier-Vorrichtung vorhanden, um während einer NMR-Messung Gas auf einer ersten variablen Temperatur T₁ in die Probenkammer 3 und durch den MAS-Stator 4 hindurchzuleiten, um die Temperatur der NMR-Messprobe 5 einzustellen und um gleichzeitig Druckgas auf einer zweiten variablen Temperatur T₂ um die Probenkammer 3 herum zu leiten.

Erfindungsgemäß zeichnet sich der NMR-Probenkopf 1 gegenüber dem bekannten Stand der Technik dadurch aus, dass die Probenkammer 3 mittels einer **Kapsel-Einrichtung 6** mindestens in azimutaler Richtung um die Achse der Magnetbohrung 2 sowie entgegen der Strömungsrichtung des Druckgases umschlossen und derart angeordnet ist, dass ein **Luftspalt 7** zwischen der Probenkammer 3 und der Magnetbohrung 2 der NMR-MAS-Anordnung vorhanden ist.

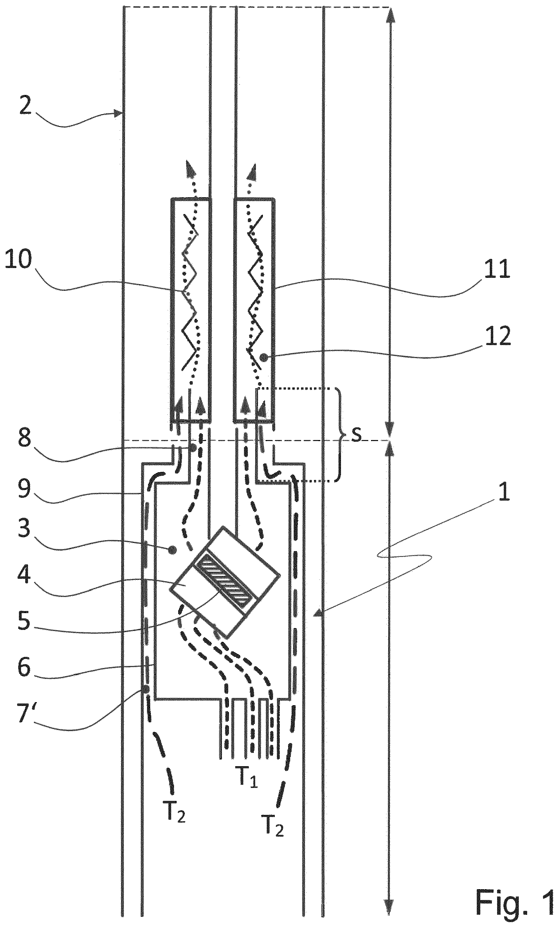

Bei der Ausführungsform nach **Fig.** 1 ist der MAS-Stator 4 von einem **Abschirmrohr 9** aus elektrisch leitfähigem Material zum Abschirmen von HF-Strahlung umgeben. Die Kapsel-Einrichtung 6 ist hier derart innerhalb des Abschirmrohres 9 angeordnet, dass der Gasstrom mit dem Druckgas auf der zweiten variablen Temperatur T₂ außerhalb der Probenkammer 3 durch einen **Luftspalt 7'** zwischen der Kapsel-Einrichtung 6 und dem Abschirmrohr 9 -und damit auch zwischen der Probenkammer 3 und der Magnetbohrung 2-hindurch geleitet wird.

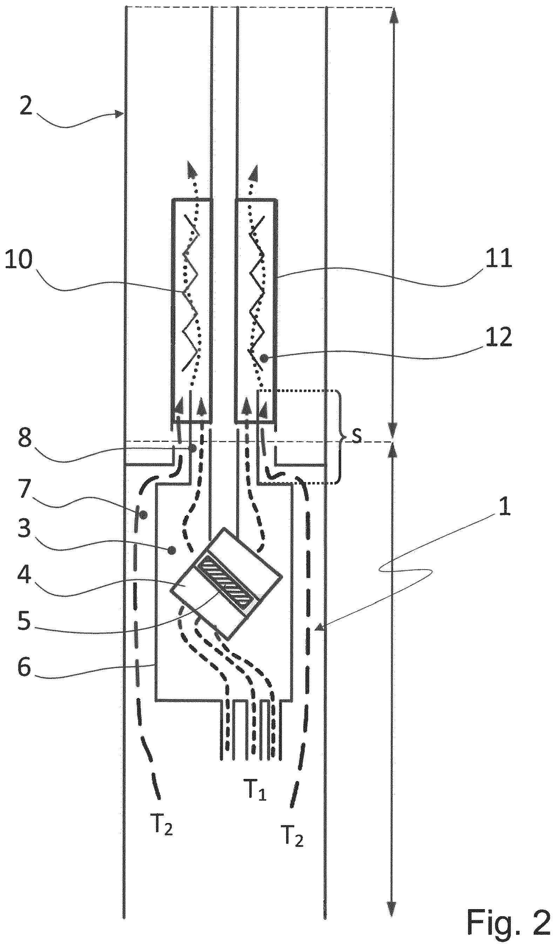

Die in **Fig. 2** dargestellte, etwas einfachere Ausführungsform unterscheidet sich von derjenigen nach Fig. 1 dadurch, dass hier das Abschirmrohr 9 weggelassen ist. Die Funktion der Abschirmung der Probenkammer 3 gegen äußere HF-Strahlung sowie auch der Außenwelt gegen die von den HF-Spulen erzeugte Strahlung in der Probenkammer 3 erfolgt bei dieser Ausführungsform im Wesentlichen durch die Magnetbohrung 2. Der Luftspalt 7 verläuft daher zwischen der Probenkammer 3 und der Magnetbohrung 2.

Bei beiden in der Zeichnung dargestellten Ausführungsformen des erfindungsgemäßen Probenkopfes 1 ist jeweils ein **Abgassystem 8** vorgesehen, welches die Gasströme auf der ersten variablen Temperatur T₁ und auf der zweiten variablen Temperatur T₂ räumlich voneinander getrennt aus dem Probenkopf 1 hinausleitet. Die aus der Probenkammer 3 austretenden Gasströme werden zumindest auf einem Teil der Strecke s thermisch voneinander isoliert geführt. Zudem ist das Abgassystem 8 derart ausgebildet, dass die aus der Probenkammer 3 austretenden Gasströme nach Bedarf gemeinsam oder einzeln geheizt und/oder gekühlt und/oder vermischt werden können.

In dem vom MAS-Stator 4 abgewandten Teil des Abgassystems 8 ist eine **Heiz**- **bzw. Kühleinrichtung 10** vorgesehen, die als elektrische Heizwendel, als Pelletierelement bzw. als Wärmetauscher ausgeführt sein kann, und mit welcher aus der Probenkammer 3 austretende Gasströme, vorzugsweise das Gas von variabler Temperatur T₁, bei Bedarf aufgeheizt oder abgekühlt werden können.

Im Anschluss an das Abgassystem 8 ist ein **Transfersystem 11** angeschlossen, in welchem die Abgasströme weiterhin voneinander getrennt auf einer Strecke s geführt werden, insbesondere bis zu einer **Mischkammer 12.**

Zwischen der gekapselten Probenkammer 3 und dem Abschirmrohr 9 befindet sich ein -vorzugsweise umlaufender- Luftspalt 7; 7', in dem ein zusätzlicher Gasstrom mit Raumtemperatur geführt wird, so dass der Wärmeübergang zwischen Probenkammer 3 und Abschirmrohr 9 dadurch erschwert wird. Der Luftspalt 7; 7' ist so ausgelegt, dass die umströmende Luft die von der Probenkammer 3 abgegebene Wärmemenge aufnimmt. Im vorliegenden Fall ist der Luftspalt 7; 7' im Bereich von 0,1 - 1,0 mm dimensioniert. Das Prinzip funktioniert auch für größere oder kleinere Luftspalte; ausschlaggebend ist hier die Strömungsgeschwindigkeit an der zu temperierenden Oberfläche und die maximale/minimale Temperatur an der zu isolierenden Oberfläche. Diese Verengung unterscheidet die erfindungsgemäße Temperierung vom Stand der Technik, bei dem ebenfalls Flushgase (Spülgase) innerhalb eines Abschirmrohres geführt werden. Durch die Verengung jedoch wird das Flushgas in seiner Strömungsgeschwindigkeit beschleunigt und kann somit wesentlich effizienter die Wärme oder Kälte der Probenkammer 3 aufnehmen. Der Luftstrom beträgt etwa 2 bis 50 Normliter/min, vorzugsweise 10 bis 25 Normliter/min. Ein Wärmeübergang zum Abschirmrohr 9 ist somit quasi unterbunden (thermische Isolation).

In den Figuren ist gezeigt, wie die Probenkammer 3 verkapselt ist und wie das Flushgas um die Kammer herum strömt.

Sowohl der Gasstrom auf der ersten variablen Temperatur T₁, als auch der Gasstrom auf der zweiten variablen Temperatur T₂ werden getrennt bis nach außen geführt. Damit werden die heißenlkalten MAS-Arbeitsgase aus der Probenkammer 3 thermisch isoliert nach außen geführt und können dort bei Bedarf gemischt/geheizt/gekühlt werden. Die "Isolationsstrecke" wird also auch oberhalb der Probenkammer 3 fortgeführt und kann ggf. nach oben verlängert werden. Diese Maßnahme leitet alle Gase mit potentiell kritischer Temperatur aus dem sensitiven Bereich innerhalb des Magneten.

Auf die obere Probenkopf-Schnittstelle wird optional ein Transfersystem 11 angeschlossen, das diese getrennten Gasströme weiterhin getrennt führt, bis diese in einer Mischkammer 12 gemischt und ggf. beheizt werden können, so dass das aus dem Probenkopf 1 abströmende Gasgemisch sich erst außerhalb des Probenkopfes mit der Umgebungsluft mischt. Das Transfersystem 11 nimmt die aus dem Abschirmrohr 9 strömenden Gase auf und führt sie zunächst durch die in Spektrometern üblicherweise eingebauten HR-Turbinen, bevor sie vermischt und ggf. mittels Heizwendel aufgeheizt werden, damit das Spektrometer nicht vereist.

### Bezugszeichenliste:

- 1: NMR-Probenkopf
- 2: Magnetbohrung
- 3: Probenkammer
- 4: MAS-Stator
- 5: NMR-Messprobe
- 6: Kapsel-Einrichtung
- 7: Luftspalt zwischen Probenkammer und Magnetbohrung
- 7': Luftspalt zwischen Probenkopf und Magnetbohrung
- 8: Abgassystem
- 9: HF-Abschirmrohr
- 10: Heiz- bzw. Kühleinrichtung
- 11: Transfersystem
- 12: Mischkammer

### Referenzliste

Für die Beurteilung der Patentfähigkeit in Betracht gezogene Publikationen:
[1] US 4,587,492 A
[2] US 2010/0026302 A1
[3] US 2015/0048829 A1
[4] US 2005/0122107 A1

## Patentansprüche

1. MAS-Probenkopf (1), der so ausgebildet ist, dass er im Betrieb in einer Magnetbohrung (2) einer NMR-MAS-Anordnung angeordnet sein kann, mit einer Probenkammer (3), welche einen MAS-Stator (4) zur Aufnahme eines MAS-Rotors sowie eine HF-Spule umfasst, die zum Einstrahlen von HF-Pulsen in eine NMR-Messprobe (5) und/oder zum Empfangen von HF-Signalen aus der NMR-Messprobe (5) dient, wobei eine Temperier-Vorrichtung vorhanden ist, um während einer NMR-Messung Gas auf einer ersten variablen Temperatur T₁ in die Probenkammer (3) und durch den MAS-Stator (4) hindurch zu leiten um die Temperatur der NMR-Messprobe (5) einzustellen und um gleichzeitig Druckgas auf einer zweiten variablen Temperatur T₂ um die Probenkammer (3) herum zu leiten,
**dadurch gekennzeichnet,**
**dass** der MAS-Stator (4) von einem Abschirmrohr (9) des MAS-Probenkopfs (1) aus elektrisch leitfähigem Material zum Abschirmen von HF-Strahlung umgeben ist, und
**dass** der MAS-Probenkopf (1) eine Kapsel-Einrichtung (6) enthält, deren Innenraum die Probenkammer (3) definiert, wobei die Probenkammer (3) von der Kapsel-Einrichtung (6) mindestens in azimutaler Richtung in Bezug auf eine Achse der Magnetbohrung (2) sowie entgegen der Strömungsrichtung des Druckgases umschlossen ist, wobei sich ein Luftspalt (7') zwischen der Kapsel-Einrichtung (6) und dem Abschirmrohr (9) der NMR-MAS-Anordnung ergibt, und dass die Kapsel-Einrichtung (6) derart innerhalb des Abschirmrohres (9) angeordnet ist, dass der Gasstrom mit dem Druckgas auf der zweiten variablen Temperatur T₂ außerhalb der Probenkammer (3) durch den Luftspalt (7') zwischen der Kapsel-Einrichtung (6) und dem Abschirmrohr (9) hindurch geleitet wird.

2. Probenkopf nach Anspruch 1, **dadurch gekennzeichnet, dass** elektronische Bauteile umfassend Resonator-Strukturen und elektrische Übertragungsleitungen, vorzugsweise sämtliche elektronischen Bauteile mit Ausnahme der HF-Spule, außerhalb der Kapsel-Einrichtung (6), insbesondere im Bereich des Druckgases auf der zweiten variablen Temperatur T₂, angeordnet sind.

3. Probenkopf nach Anspruch 1 oder 2, **dadurch gekennzeichnet, dass** ein Abgassystem (8) vorgesehen ist, welches die Gasströme auf der ersten variablen Temperatur T₁ und auf der zweiten variablen Temperatur T₂ räumlich voneinander getrennt aus dem Probenkopf (1) hinausleitet.

4. Probenkopf nach einem der vorhergehenden Ansprüche, **dadurch gekennzeichnet, dass** der Luftspalt (7') zwischen Probenkammer (3) und Abschirmrohr (9) zur Durchleitung des Druckgases auf der zweiten variablen Temperatur T₂ azimutal umlaufend innerhalb des Abschirmrohrs (9) ausgebildet ist.

5. Probenkopf nach Anspruch 4, **dadurch gekennzeichnet, dass** die Kapsel-Einrichtung (6) und das Abschirmrohr (9) jeweils eine zylindrische Form mit parallelen, insbesondere identischen, Zylinderachsen haben, und dass der Luftspalt (7') zwischen Kapsel-Einrichtung (6) und Abschirmrohr (9) umlaufend mit gleichem Querschnitt gestaltet ist.

6. Probenkopf nach einem der vorhergehenden Ansprüche, **dadurch gekennzeichnet, dass** der Luftspalt (7') zwischen Probenkammer (3) und Abschirmrohr (9) zur Durchleitung des Druckgases auf der zweiten variablen Temperatur T₂ eine sich in axialer Richtung des Abschirmrohrs (9) erstreckende radiale Verengung im axialen Bereich der Probenkammer (3) aufweist, die vorzugsweise zwischen 0,1mm und 1mm beträgt.

7. Probenkopf nach einem der vorhergehenden Ansprüche, **dadurch gekennzeichnet, dass** der Luftspalt (7') zwischen Probenkammer (3) und Abschirmrohr (9) zur Durchleitung des Druckgases auf der zweiten variablen Temperatur T₂ so ausgelegt ist, dass ein Gasstrom mit einer Gasmenge von 2 bis 50 Normliter/min, vorzugsweise zwischen 10 und 25 Normliter/min, hindurch strömen kann.

8. Probenkopf nach einem der Ansprüche 3, sowie 4 bis 7, sofern von Anspruch 3 abhängig, **dadurch gekennzeichnet, dass** sich das Abgassystem (8) um eine Strecke s vom MAS-Stator (4) weg in das Abschirmrohr (9) erstreckt, die größer ist als der maximale Außendurchmesser des MAS-Stators (4), insbesondere s > 3cm.

9. Probenkopf nach Anspruch 8, **dadurch gekennzeichnet, dass** die aus der Probenkammer (3) austretenden Gasströme zumindest auf einem Teil der Strecke s thermisch voneinander isoliert geführt werden.

10. Probenkopf nach einem der Ansprüche 3, sowie 4 bis 9, sofern von Anspruch 3 abhängig, **dadurch gekennzeichnet, dass** das Abgassystem (8) derart ausgebildet ist, dass die aus der Probenkammer (3) austretenden Gasströme nach Bedarf gemeinsam oder einzeln geheizt und/oder gekühlt und/oder vermischt werden können.

11. Probenkopf nach Anspruch 10, **dadurch gekennzeichnet, dass** in dem vom MAS-Stator (4) abgewandten Teil des Abgassystems (8) eine Heiz- bzw. Kühleinrichtung (10), vorzugsweise eine elektrische Heizwendel bzw. ein Wärmetauscher, vorgesehen ist, mit welcher aus der Probenkammer (3) austretende Gasströme, vorzugsweise das Gas von variabler Temperatur T₁, bei Bedarf aufgeheizt oder abgekühlt werden können.

12. Probenkopf nach einem der Ansprüche 3 bis 11, **dadurch gekennzeichnet, dass** im Anschluss an das Abgassystem (8) ein Transfersystem (11) angeschlossen ist, in welchem die Abgasströme weiterhin voneinander getrennt geführt werden, insbesondere bis zu einer Mischkammer (12).

13. System umfassend einen MAS-Probenkopf (1) in Kombination mit einem Magneten einer NMR-MAS-Anordnung, wobei der MAS-Probenkopf (1) so ausgebildet ist, dass er im Betrieb in einer Magnetbohrung (2) des Magneten angeordnet sein kann, mit einer Probenkammer (3), welche einen MAS-Stator (4) zur Aufnahme eines MAS-Rotors sowie eine HF-Spule umfasst, die zum Einstrahlen von HF-Pulsen in eine NMR-Messprobe (5) und/oder zum Empfangen von HF-Signalen aus der NMR-Messprobe (5) dient, wobei eine Temperier-Vorrichtung vorhanden ist, um während einer NMR-Messung Gas auf einer ersten variablen Temperatur T₁ in die Probenkammer (3) und durch den MAS-Stator (4) hindurch zu leiten um die Temperatur der NMR-Messprobe (5) einzustellen und um gleichzeitig Druckgas auf einer zweiten variablen Temperatur T₂ um die Probenkammer (3) herum zu leiten,
**dadurch gekennzeichnet,**
**dass** der MAS-Probenkopf (1) eine Kapsel-Einrichtung (6) enthält, deren Innenraum die Probenkammer (3) definiert, wobei die Probenkammer (3) von der Kapsel-Einrichtung (6) mindestens in azimutaler Richtung um die Achse der Magnetbohrung (2) sowie entgegen der Strömungsrichtung des Druckgases umschlossen ist und sich ein Luftspalt (7; 7') zwischen der Kapseleinrichtung (6) und der Magnetbohrung (2) der NMR-MAS-Anordnung ergibt.

14. Verfahren zum Betrieb einer NMR-MAS-Anordnung mit einem MAS-Probenkopf (1) nach einem der Ansprüche 1 bis 12, **dadurch gekennzeichnet, dass** die Temperatur der Gasströme auf der ersten variablen Temperatur T₁ zwischen -120°C und 400°C und das Druckgas auf der zweiten variablen Temperatur T₂ zwischen 10 und 30°C gehalten wird.

## Claims

1. An MAS probehead (1), which is designed in such a way that it can be placed inside a magnet bore (2) of an NMR-MAS arrangement during operation, having a sample chamber (3), which comprises an MAS stator (4) for receiving an MAS rotor and an RF coil that serves to radiate RF pulses into an NMR sample (5) and/or to receive RF signals from the NMR sample (5), wherein a temperature-control apparatus is present in order to guide gas at a first variable temperature T₁ into the sample chamber (3) and through the MAS stator (4) during an NMR measurement so as to adjust the temperature of the NMR sample (5) and in order to simultaneously guide pressurized gas at a second variable temperature T₂ around the sample chamber (3),
**characterized in that**
the MAS stator (4) is surrounded by a shielding tube (9) of the MAS probehead (1), which is made of electrically conducting material, for shielding against RF radiation, and
that the MAS probehead (1) contains an encapsulation device (6), the interior of which defines the sample chamber (3), wherein the sample chamber (3) is surrounded by the encapsulation device (6), at least in the azimuthal direction with respect to an axis of the magnet bore (2) and counter to the flow direction of the pressurized gas,
wherein an air gap (7') is resulting between the encapsulation device (6) and the shielding tube (9) of the NMR-MAS arrangement, and that the encapsulation device (6) is located within the shielding tube (9) in such a way that the gas flow with the pressurized gas at the second variable temperature T₂ is guided outside of the sample chamber (3) through the air gap (7') between the encapsulation device (6) and the shielding tube (9).

2. The probehead as claimed in claim 1, **characterized in that** electronic components comprising resonator structures and electrical transmission lines, preferably all electronic components with the exception of the RF coil, are arranged outside of the encapsulation device (6), in particular in the region of the pressurized gas at the second variable temperature T₂.

3. The probehead as claimed in claim 1 or 2, **characterized in that** an exhaust gas system (8) is provided, which guides the gas flows at the first variable temperature T₁ and at the second variable temperature T₂ from the probehead (1) in spatially separated fashion.

4. The probehead as claimed in any one of the preceding claims, **characterized in that** the air gap (7') is shaped in azimuthal circumferential fashion arranged within the shielding tube (9) between the sample chamber (3) and the shielding tube (9) to pass the pressurized gas at the second variable temperature T₂.

5. The probehead as claimed in claim 4, **characterized in that** the encapsulation device (6) and the shielding tube (9) each have a cylindrical form with parallel cylinder axes, in particular identical cylinder axes, and that the air gap (7') between the encapsulation device (6) and the shielding tube (9) is designed circumferentially with the same cross section.

6. The probehead as claimed in any one of the preceding claims, **characterized in that** the air gap (7') between the sample chamber (3) and the shielding tube (9) for passing the pressurized gas at the second variable temperature T₂ has a radial narrowing, which extends in the axial direction of the shielding tube (9), in the axial region of the sample chamber (3), said narrowing preferably being between 0.1 mm and 1 mm.

7. The probehead as claimed in any one of the preceding claims, **characterized in that** the air gap (7') between the sample chamber (3) and the shielding tube (9) for passing the pressurized gas at the second variable temperature T₂ is designed in such a way that a gas flow with a gas quantity of 2 to 50 standard liter/min, preferably of between 10 and 25 standard liter/min, can flow therethrough.

8. The probehead as claimed in any one of the claims 3, and 4 to 7 as far as depending on claim 3, **characterized in that** the exhaust gas system (8) extends a distance s from the MAS stator (4) into the shielding tube (9), said distance being greater than the maximum external diameter of the MAS stator (4), in particular s > 3 cm.

9. The probehead as claimed in claim 8, **characterized in that** the gas flows emerging from the sample chamber (3) are guided in thermal isolation from one another along at least a part of the distance s.

10. The probehead as claimed in any one of the claims 3, and 4 to 9 as far as depending on claim 3, **characterized in that** the exhaust gas system (8) is embodied in such a way that the gas flows emerging from the sample chamber (3) can be heated and/or cooled and/or mixed, together or individually, depending on requirements.

11. The probehead as claimed in claim 10, **characterized in that** a heating or cooling device (10), preferably an electric heating coil or a heat exchanger, is provided in the part of the exhaust gas system (8) distant from the MAS stator (4), said heating or cooling device being used, where necessary, to heat or cool gas flows emerging from the sample chamber (3), preferably the gas at variable temperature T₁.

12. The probehead as claimed in any one of claims 3 to 11, **characterized in that** a transfer system (11) is connected following the exhaust gas system (8), in which the exhaust gas flows are still guided separately from one another, in particular up to a mixing chamber (12).

13. System, comprising an MAS probehead (1) in combination with a magnet of an NMR-MAS arrangement, wherein the MAS probehead (1) is designed in such a way that it can be placed inside a magnet bore (2) of the magnet during operation, having a sample chamber (3), which comprises an MAS stator (4) for receiving an MAS rotor and an RF coil that serves to radiate RF pulses into an NMR sample (5) and/or to receive RF signals from the NMR sample (5), wherein a temperature-control apparatus is present in order to guide gas at a first variable temperature T₁ into the sample chamber (3) and through the MAS stator (4) during an NMR measurement so as to adjust the temperature of the NMR sample (5) and in order to simultaneously guide pressurized gas at a second variable temperature T₂ around the sample chamber (3),
**characterized in that**
the MAS probehead (1) contains an encapsulation device (6), the interior of which defines the sample chamber (3), wherein the sample chamber (3) is surrounded by the encapsulation device (6), at least in the azimuthal direction around the axis of the magnet bore (2) and counter to the flow direction of the pressurized gas,
wherein an air gap (7; 7') is resulting between the encapsulation device (6) and the magnet bore (2) of the NMR-MAS arrangement.

14. A method for operating an NMR-MAS arrangement comprising an MAS probehead (1) as claimed in any one of the claims 1 to 12, **characterized in that** the temperature of the gas flows at the first variable temperature T₁ is maintained between -120°C and 400°C and the pressurized gas at the second variable temperature T₂ is maintained between 10 and 30°C.

## Revendications

1. Tête d'échantillonnage MAS (1) qui est conçue pour pouvoir être agencée en fonctionnement dans un alésage d'aimant (2) d'un agencement de RMN-MAS, comprenant une chambre à échantillon (3) qui présente un stator MAS (4) destiné à recevoir un rotor MAS et une bobine HF, qui sert à émettre des impulsions HF dans un échantillon de mesure de RMN (5) et/ou à recevoir des signaux HF à partir de l'échantillon de mesure de RMN (5), dans laquelle un dispositif de régulation de température est prévu, pour diriger un gaz à une première température variable T₁ dans la chambre à échantillon (3) et à travers le stator MAS (4) pendant une mesure de RMN afin de régler la température de l'échantillon de mesure de RMN (5) et de diriger simultanément un gaz sous pression à une seconde température variable T₂ autour de la chambre à échantillon (3),
**caractérisée en ce que**
le stator MAS (4) est entouré d'un tube de protection (9) de la tête d'échantillonnage MAS (1) en matériau électriquement conducteur pour une protection à l'encontre d'un rayonnement HF, et
la tête d'échantillonnage MAS (1) contient un dispositif de capsule (6) dont l'espace intérieur définit la chambre à échantillon (3), la chambre à échantillon (3) étant entourée par le dispositif de capsule (6) au moins dans la direction azimutale par rapport à un axe de l'alésage d'aimant (2) ainsi qu'à l'encontre de la direction d'écoulement du gaz sous pression, un entrefer (T) étant formé entre le dispositif de capsule (6) et le tube de protection (9) de l'agencement de RMN-MAS, et **en ce que** le dispositif de capsule (6) est agencé à l'intérieur du tube de protection (9) de telle sorte que l'écoulement de gaz avec le gaz sous pression à la seconde température variable T₂ à l'extérieur de la chambre à échantillon (3) est conduit à travers l'entrefer (T) entre le dispositif de capsule (6) et le tube de protection (9).

2. Tête d'échantillonnage selon la revendication 1, **caractérisée en ce que** des composants électroniques comprenant des structures de résonateur et des lignes de transmission électriques, de préférence tous les composants électroniques à l'exception de la bobine HF, sont agencés à l'extérieur du dispositif de capsule (6), en particulier dans la zone du gaz sous pression à la seconde température variable T₂.

3. Tête d'échantillonnage selon la revendication 1 ou 2, **caractérisée en ce qu'**un système de gaz d'échappement (8) est prévu, qui évacue les écoulements de gaz à partir de la tête d'échantillonnage à la première température variable T₁ et à la seconde température variable T₂ séparément l'une de l'autre dans l'espace.

4. Tête d'échantillonnage selon l'une quelconque des revendications précédentes, **caractérisée en ce que** l'entrefer (T) entre la chambre à échantillon (3) et le tube de protection (9) pour le passage du gaz sous pression à la seconde température variable T₂ est formé de manière à circuler de manière azimutale à l'intérieur du tube de protection (9).

5. Tête d'échantillonnage selon la revendication 4, **caractérisée en ce que** le dispositif de capsule (6) et le tube de protection (9) présentent chacun une forme cylindrique avec des axes de cylindre parallèles, en particulier identiques, et **en ce que** l'entrefer (T) entre le dispositif de capsule (6) et le tube de protection (9) est conçu de manière périphérique avec la même section transversale.

6. Tête d'échantillonnage selon l'une quelconque des revendications précédentes, **caractérisée en ce que** l'entrefer (T) entre la chambre à échantillon (3) et le tube de protection (9) pour le passage du gaz sous pression à la seconde température variable T₂ présente un rétrécissement radial dans la zone axiale de la chambre à échantillon (3), s'étendant dans la direction axiale du tube de protection (9), qui est de préférence compris entre 0,1 mm et 1 mm.

7. Tête d'échantillonnage selon l'une quelconque des revendications précédentes, **caractérisée en ce que** l'entrefer (T) entre la chambre à échantillon (3) et le tube de protection (9) pour le passage du gaz sous pression à la seconde température variable T₂ est conçu de telle sorte qu'un écoulement de gaz avec une quantité de gaz de 2 à 50 litres standard/min, de préférence entre 10 et 25 litres standard/min, peut circuler à travers celui-ci.

8. Tête d'échantillonnage selon l'une quelconque des revendications 3 et 4 à 7, lorsqu'elles dépendent de la revendication 3, **caractérisée en ce que** le système de gaz d'échappement (8) s'étend sur une distance s à partir du stator MAS (4) dans le tube de protection (9), qui est supérieure au diamètre extérieur maximal du stator MAS (4), en particulier s > 3 cm.

9. Tête d'échantillonnage selon la revendication 8, **caractérisée en ce que** les écoulement de gaz sortant de la chambre à échantillon (3) sont guidés isolés thermiquement l'un de l'autre au moins sur une partie de la distance s.

10. Tête d'échantillonnage selon l'une des revendications 3 et 4 à 9, lorsqu'elles dépendent de la revendication 3, **caractérisée en ce que** le système de gaz d'échappement (8) est conçu de telle manière que les écoulements de gaz sortant de la chambre à échantillon (3) peuvent être chauffés et/ou refroidis et/ou mélangés conjointement ou individuellement selon les besoins.

11. Tête d'échantillonnage selon la revendication 10, **caractérisée en ce qu'**un dispositif de chauffage ou de refroidissement (10), de préférence un serpentin de chauffage électrique ou un échangeur de chaleur, est prévu dans la partie du système de gaz d'échappement (8) opposée au stator MAS (4), avec lequel des écoulement de gaz sortant de la chambre à échantillon (3), de préférence le gaz à température variable T₁, peuvent être chauffés ou refroidis si nécessaire.

12. Tête d'échantillonnage selon l'une quelconque des revendications 3 à 11, **caractérisée en ce qu'**un système de transfert (11) est raccordé à la suite du système de gaz d'échappement (8), dans lequel les écoulement de gaz d'échappement sont en outre guidés mutuellement séparés, en particulier jusqu'à une chambre de mélange (12).

13. Système comprenant une tête d'échantillonnage MAS (1) en combinaison avec un aimant d'un agencement de RMN-MAS, dans lequel la tête d'échantillonnage MAS (1) est configurée de telle sorte qu'en fonctionnement, elle peut être disposée dans un alésage d'aimant (2) de l'aimant, comprenant une chambre à échantillon (3) qui présente un stator MAS (4) destiné à recevoir un rotor MAS et une bobine HF, qui sert à émettre des impulsions HF dans un échantillon de mesure de RMN (5) et/ou à recevoir des signaux HF à partir de l'échantillon de mesure de RMN (5), dans laquelle un dispositif de régulation de température est prévu, pour diriger un gaz à une première température variable T₁ dans la chambre à échantillon (3) et à travers le stator MAS (4) pendant une mesure de RMN afin de régler la température de l'échantillon de mesure de RMN (5) et de diriger simultanément un gaz sous pression à une seconde température variable T₂ autour de la chambre à échantillon (3),
**caractérisé en ce que**
la tête d'échantillonnage MAS (1) contient un dispositif de capsule (6) dont l'espace intérieur définit la chambre à échantillon (3), la chambre à échantillon (3) étant entourée par le dispositif de capsule (6) au moins dans la direction azimutale par rapport à un axe de l'alésage d'aimant (2) ainsi qu'à l'encontre de la direction d'écoulement du gaz sous pression, un entrefer (7 ; 7') étant formé entre le dispositif de capsule (6) et l'alésage d'aimant (2) de l'agencement de RMN-MAS.

14. Procédé pour faire fonctionner un agencement de RMN-MAS comprenant une tête d'échantillonnage MAS (1) selon l'une quelconque des revendications 1 à 12, **caractérisé en ce que** la température des écoulements de gaz à la première température variable T₁ est maintenue entre -120°C et 400°C et la température du gaz comprimé à la seconde température variable T₂ est maintenue entre 10°C et 30°C.
